# EUROPEAN PATENT SPECIFICATION

(11) **EP 2 610 921 B1**
(45) Date of publication and mention of the grant of the patent: **20.11.2019**
(21) Application number: 11822022.7
(22) Date of filing: 27.04.2011
(51) Int. Cl.: H01L 31/042, H01L 31/0224

(54) **SOLAR CELL AND SOLAR CELL MODULE INCLUDING SAME**
SOLARZELLE UND SOLARZELLENMODUL DAMIT
CELLULE SOLAIRE ET MODULE À CELLULE SOLAIRE COMPRENANT LADITE CELLULE SOLAIRE

(30) Priority: 01.09.2010 KR 20100085582
(43) Date of publication of application: 03.07.2013
(73) Proprietor: LG Innotek Co., Ltd., Seoul, 04637 (KR)
(72) Inventor: BAE, Do Won, Seoul 100-714 (KR)
(74) Representative: Novagraaf Technologies
(86) International application number: PCT/KR2011/003122
(87) International publication number: WO 2012/030047

(56) References cited:
- WO-A1-2009/112503
- WO-A2-2009/097588
- JP-A- S61 163 671
- JP-A- 2000 124 491
- JP-A- 2005 286 070
- JP-A- 2009 065 022
- US-A- 5 759 291

## Description

### Technical Field

The embodiment relates to a solar cell and a solar cell module including the same.

### Background Art

Recently, as energy consumption is increased, a solar cell has been developed to convert solar energy into electrical energy. The solar cell has an important issue to improve the photoelectric conversion efficiency.

The document JP61163671 discloses a thin film photovoltaic device with the electrodes extending around the lateral edges of the substrate so that the output current collection takes place on the reverse side of said substrate.

### Disclosure

### Technical Problem

The embodiment provides a solar cell capable of increasing an effective region which can generate electrical energy by absorbing the solar light, and a solar cell module including the same.

### Technical Solution

According to the present invention, there is provided a solar cell as defined in claim 1.

Meanwhile, a solar cell module according to the embodiment includes the solar cell and a junction box disposed on the second surface of the support substrate.

### Advantageous Effects

As described above, according to the solar cell of the embodiment, since the collecting electrode is positioned on the bottom surface of the support substrate, the area of the photoelectric conversion part positioned on the top surface of the support substrate can be maximized. Accordingly, the effective area of the solar cell can be increased. In addition, since the extension part and the collecting electrode are positioned on the bottom surface of the support substrate, which does not receive the solar light, the extension part and the collecting electrode can be formed with the wide area. Accordingly, the contact resistance can be reduced so that the efficiency of the solar cell can be improved.

In addition, since the extension part extends to the bottom surface of the support substrate while surrounding the lateral side of the support substrate. Accordingly, the collect electrode can be positioned on the bottom surface of the support substrate in the simple structure.

In addition, since the junction box is positioned on the bottom surface of the support substrate, the collecting electrode can be aligned in line with the junction box. Accordingly, the connection structure between the collecting electrode and the junction box can be simplified.

### Description of Drawings

FIG. 1 is a plan view showing a solar cell module according to the embodiment;
FIG. 2 is a sectional view taken along line **I-II** of FIG. 1;
FIG. 3 is a bottom view showing the solar cell module according to the embodiment;
FIG. 4 is a bottom view showing a solar cell module according to a modification;
FIGS. 5 to 8 are sectional views showing the manufacturing process of a solar cell according to a first embodiment; and
FIGS. 9 to 11 are sectional views showing the manufacturing process of a solar cell according to a second embodiment.

### Best Mode for Invention

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. The thickness and size of each layer (or film), each region, each pattern, or each structure shown in the drawings may be exaggerated, omitted or schematically drawn for the purpose of convenience or clarity. In addition, the size of elements does not utterly reflect an actual size.

Hereinafter, the embodiment will be described in detail with reference to accompanying drawings.

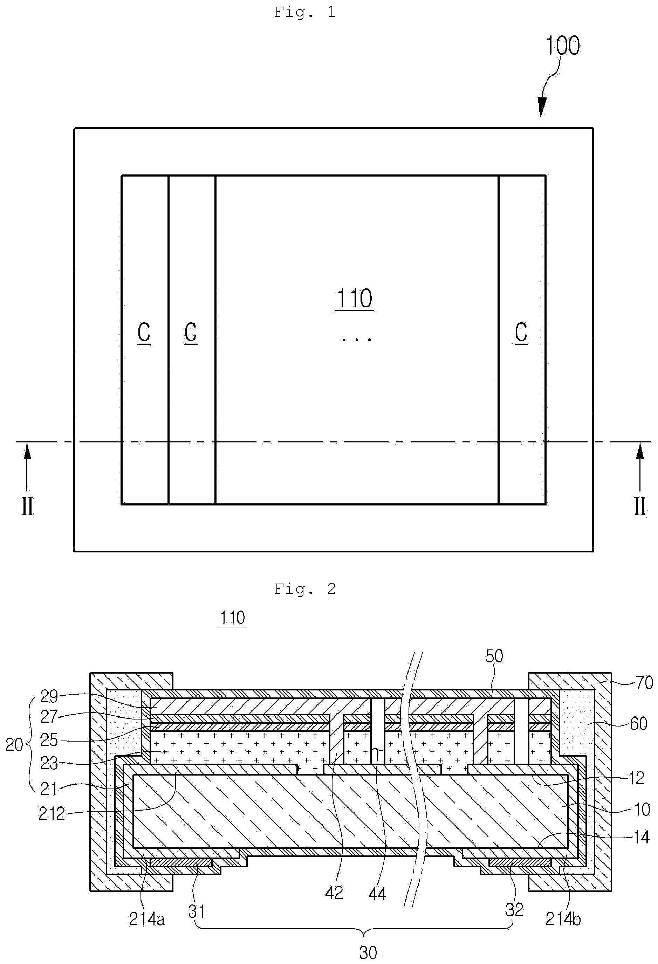

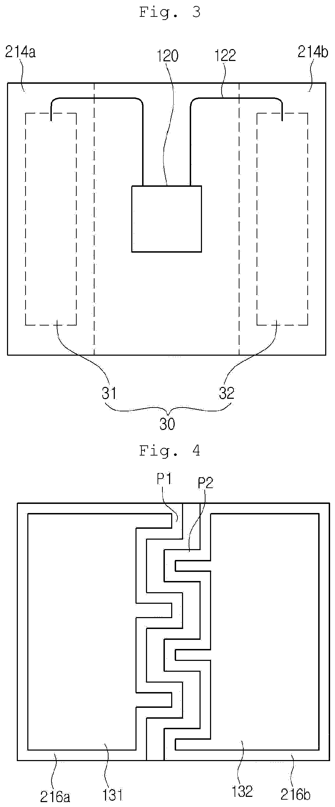

FIG. 1 is a plan view showing a solar cell module according to the embodiment, FIG. 2 is a sectional view taken along line **I-II** of FIG. 1, and FIG. 3 is a bottom view showing the solar cell module according to the embodiment.

Referring to FIGS. 1 to 3, a solar cell module 100 according to the embodiment includes a solar cell 110 and a junction box 120 of stably collecting electricity generated from the solar cell 110 to prevent the reversal current of the electricity.

In this case, referring to FIG. 2, the solar cell 110 includes a support substrate 10, a photoelectric conversion part 20 formed on the support substrate 10, and a collecting electrode 30 to collect electricity generated from the photoelectric conversion part 20. According to the present embodiment, a plurality of photoelectric conversion parts 20 are provided, and adjacent photoelectric conversion parts 20 are connected to each other in series, thereby defining a plurality of cells. Hereinafter, the details thereof will be made in detail below.

The support substrate 10 has a plate shape, and supports the photoelectric conversion part 20 and the collecting electrode 30 formed thereon. The support substrate 10 may include an insulator including glass or plastic. For example, the support substrate 10 may include soda lime glass . However, the embodiment is not limited thereto, and the support substrate 10 may include a metallic substrate. In other words, the support substrate 10 may include a rigid material or a flexible material according to the characteristics of the solar cell module 100.

Each photoelectric conversion part 20 formed ona first surface 12 (the top in drawings; hereinafter, referred to as "top surface") includes a first electrode 21, a light absorbing layer 23, and a second electrode (window layer) 29. Hereinafter, the connection structure of adjacent photoelectric conversion parts 20 will be described after describing the photoelectric conversion parts 20 while focusing on one photoelectric conversion part 30.

The first electrode 21 may include a material representing superior electrical characteristics. For example, the first electrode 21 may include molybdenum (Mo), copper (Cu), nickel (Ni), aluminum (Al), or the alloy thereof.

A light absorbing layer 23 is formed on the first electrode 21 to convert the solar light into the electrical energy. According to the present embodiment, the light absorbing layer 23 may include a non-silicon semiconductor material.

The light absorbing layer 23 may include a group I-III-VI compound. For example, the light absorbing layer 23 may include a Cu-In-Ga-Se (Cu (In, Ga) Se2; CIGS)-based crystal structure, a Cu-In-Se-based crystal structure, or a Cu-Ga-Se-based crystal structure.

In addition, the light absorbing layer 23 may include a group II-IV compound or a group III-IV compound. For example, the light absorbing layer 23 may include cadmium (Cd) -tellurium (Te) compound, or gallium (Ga)-arsenic (As) compound.

A buffer layer 25 and a high resistance buffer layer 27 may be formed on the light absorbing layer 23.

The buffer layer 25 is formed on the light absorbing layer 23 to reduce the difference in the lattice constant and the energy bandgap from the second electrode 29. For example, the buffer layer 25 may include CdS.

The high resistance buffer layer 27 prevents the buffer layer 25 from being damaged when forming the second electrode 29. For example, the high resistance buffer layer 27 may include zinc oxide (ZnO).

The second electrode 29 may include a transparent conductive material which is transparent to allow light to be incident into the second electrode 29 and provides the function of an electrode due to the conductivity thereof. In addition, the second electrode 29 has the characteristic of an N type semiconductor to form an N type semiconductor layer together with the buffer layer 25, thereby forming a PN junction structure together with the light absorbing layer 23 serving as a P type semiconductor layer. To this end, for example, the second electrode 29 may include Al doped zinc oxide (AZO).

According to the present embodiment, since the light absorbing layer 23 including a CIGS-based compound, a CIS-based compound, a CGS-based compound, a Cd-Te compound, or a Ga-As compound is provided, the light absorbing layer 23 can represent superior photoelectric conversion efficiency. Accordingly, the solar cell module 100 is formed with a thin thickness, so that the material can be saved, and the use range of the solar cell module 100 can be expanded. In addition, the degradation of the light absorbing layer 23 caused by the light is reduced, so that the life span of the solar cell module 100 can be increased.

However, the present embodiment is not limited thereto . Accordingly, the solar cell module 100 may include a photoelectric conversion part constituting a dye-sensitized solar cell, an organic solar cell, and a silicon solar cell.

Each photoelectric conversion part 20 corresponds to a cell C of each solar cell 110, and the adjacent photoelectric conversion parts 20 are connected to each other in series. In more detail, the first electrodes 21 may be spaced apart from each other while representing a pattern corresponding to the cell C of each solar cell 110. In addition, the light absorbing layer 23, the buffer layer 25, the high resistance buffer layer 27, and the second electrode 29 may be divided by a division pattern 44 corresponding to a cell of each solar cell 10. The first electrode 21 corresponding to a specific cell C may be connected to the second electrode 29 corresponding to a cell C adjacent to the specific cell C through a contact pattern 42 formed in the light absorbing layer 23, the buffer layer 25, and the high resistance buffer layer 27.

Therefore, each photoelectric conversion part 20 corresponding to the cell C of each solar cell 110 may be defined as the region in which the first electrode 21, the light absorbing layer 23, the buffer layer 25, the high resistance buffer layer 27, and the second electrode 29 are sequentially laminated on each other.

The collecting electrode 30 is electrically connected to at least one of the first and second electrodes 21 and 29 of the photoelectric conversion parts 20 to collect current. According to the present embodiment, the collecting electrode 30 includes first and second collecting electrodes 31 and 32, and the first and second collecting electrodes 31 and 32 are positioned at the extension parts 214a and 214b of the first electrode 21.

In more detail, the first electrode 21 includes an electrode part 212 constituting the photoelectric conversion part 20 while being placed on the top surface 12 of the support substrate 10 and the extension parts 214a and 214b extending from the top surface 12 of the support substrate 10 to a second surface 14 (the bottom of the drawings; hereinafter, referred to as "bottom surface"). The extension parts 214a and 214b include the first extension part 214a extending from the electrode part 212 placed at one side (the left side of the drawings; hereinafter, referred to as a left side) of the support substrate 10 toward the bottom surface 14 of the support substrate 10, and the second extension part 214b extending from the electrode part 212 placed at an opposite side (the right side of the drawings; hereinafter, referred to as a right side) of the support substrate 10 toward the bottom surface 14 of the support substrate 10. The first and second extension parts 214a and 214b are spaced apart from each other on the bottom surface 14 of the support substrate 10.

In this case, the first extension part 214a extends from the electrode part 212 (the most left side electrode part in the drawings) of the first electrode 21 without the contact pattern 42, and the second extension part 214b extends from the electrode part 212 (the most right side electrode part in the drawings) of the first electrode 21 directly connected to the second electrode 29 through the contact pattern 42. Accordingly, both of the first and second collecting electrodes 31 and 32 can be placed on the same first electrode 21, and the photoelectric conversion parts 20 can be connected to each other in series.

The first collecting electrode 31 makes contact with the first extension part 214a on the bottom surface 14 of the support substrate 10, and the second collecting electrode 32 makes contact with the second extension part 214b on the bottom surface 14 of the support substrate 10.

As described above, according to the present embodiment, since the first and second collecting electrodes 31 and 32 are placed on the bottom surface 14 of the support substrate 10, the area of the photoelectric conversion part 20 provided on the top surface 12 of the support substrate 10 can be maximized. In addition, according to the related art, since the first and second collecting electrodes 31 and 32 are formed on the top surface 12 of the support substrate 10 together with the photoelectric conversion part 20, the area of the photoelectric conversion part 20 must be reduced by the area of the first and second collecting electrodes 31 and 32. Accordingly, the effective area of the solar cell 110 is reduced. However, according to the present embodiment, since the first and second collecting electrodes 31 and 32 are formed on a surface different from that of the photoelectric conversion part 20, the area, in which the photoelectric conversion part 20 is formed, is maximized, so that the effective area of the solar cell 110 can be increased.

Inaddition, since the first and second extension parts 214a and 214b and the first and second collecting electrodes 31 and 32 are provided on the bottom surface 14 of the support substrate 10 that does not receive the solar light, the first and second extension parts 214a and 214b and the first and second collecting electrodes 31 and 32 may be formed with a wide area. Therefore, the efficiency of the solar cell 110 can be improved by reducing contact resistance.

In this case, the first and second extension parts 214a and 214b may be spaced apart from each other by the distance of about 60µm or more on the bottom surface 14 of the support substrate10. In other words, since the first and second extension parts 214a and214b are spaced apart from each other to the extent that the first extension part 214a is not electrically connected to the second extension part 214b, the areas of the first and second extension parts 214a and 214b and the first and second collecting electrodes 31 and 32 can be maximized.

Although FIG. 3 shows that the extension parts 214a and 214b and the first and second collecting electrodes 31 and 32 have a rectangular plane shape, the present embodiment is not limited thereto. Accordingly, as shown in FIG. 4, extension parts 216a and 216b may include protrusion parts P1 and P2, the protrusion P1 of the first extension part 216a and the protrusion part P2 of the second extension part 216b may be alternately provided, and the first and second collecting electrodes 131 and 132 may have shapes corresponding to the first and second extension parts 216a and 216b.

As described above, the first and second extension parts and the first and second collecting electrodes may be variously modified, and the modifications are within the technical scope of the present embodiment. For reference, a protective film (reference numeral 50 of FIG. 2) and the junction box (reference numeral 120 of FIG. 3) are not shown in FIG. 4 for the brief description.

Referring to FIGS. 1 and 2 again, the first and second extension parts 214a and 214b surround the lateral side of the support substrate 10 while extending to the bottom surface 14 of the support substrate 10. Accordingly, the first and second collecting electrodes 31 and 32 can be positioned on the bottom surface 14 of the support substrate 10 in the simple structure. In other words, the first and second collecting electrodes 31 and 32 can be positioned on the bottom surface 14 of the support substrate 10 through the simple manufacturing process without the process of forming additionally through holes in the support substrate 10.

For example, although the collecting electrode 30 is formed on the first electrode 21 adj acent to the support substrate 10 according to the present embodiment, the present embodiment is not limited thereto. Therefore, the collecting electrode 30 may be formed on the second electrode 29, or may be formed on each of the first and second electrodes 21 and 29.

In addition, a protective film 50 surrounds the solar cell 110 to protect the solar cell 110, and an insulating sealing member 60 is formed at the lateral side of the solar cell 110 to make the solar cell 110 in the form of a module. In addition, the material constituting the solar cell 110 can be firmly fixed by using the frame 70 surrounding the solar cell 110.

In addition, referring to FIG. 3, the junction box 120 may be positioned on the protective film 50 formed on the bottom surface 14 of the support substrate 10 having the first and second collecting electrodes 31 and 32. The first junction box 120 may receive a circuit board having diodes mounted thereon, and may be connected to the first and second collecting electrodes 31 and 32 through a cable 122. According to the present embodiment, since the first and second collecting electrodes 31 and 32 are aligned in line with the junction box 120, an additional hole used to connect the first and second collecting electrodes 31 and 32 to the junction box 120 may not be formed in the support substrate 10. As described above, since the connection structure of the first and second collecting electrodes 31 and 32 and the junction box 120 can be simplified, the size of the solar cell module 100 can be reduced, and the manufacturing process of the solar cell module 100 can be simplified.

However, the embodiment is not limited thereto, and the junction box 120 and the cable 122 may not be formed.

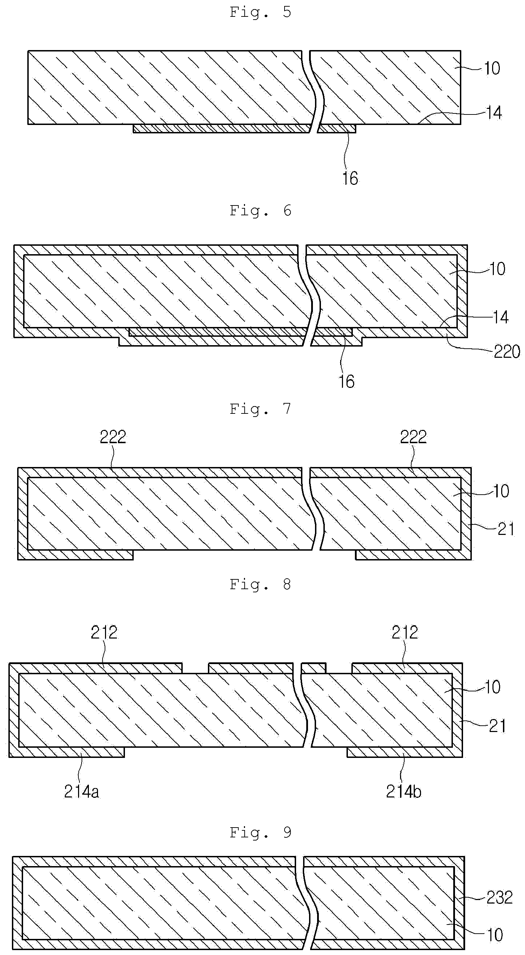

Hereinafter, the method of manufacturing the solar cell according to the first embodiment will be described in more detail with reference to FIGS. 5 to 8. FIGS. 5 to 8 are sectional views showing the manufacturing process of the solar cell according to the first embodiment.

First, as shown in FIG. 5, a tape 16 is formed on the bottom surface 14 of the support substrate 10. The tape 16 may be formed in a region without the first extension part (reference numeral 214a of FIG. 2) and the second extension part (reference numeral 214b of FIG. 2).

The tape 16 may include a mask material such as metal, ceramic, or polymer.

Thereafter, as shown in FIG. 6, a conductive material layer 220 including a conductive material is formed on the whole surface of the support substrate 10. When performing the process of forming the conductive material layer 220, the conductive material is formed on all of the front surface, the rear surface, and the lateral side of the support substrate 10 by tilting a source to supply the conductive material and/or the support substrate 10. The deposition scheme may include various processes such as an electrochemical vapor deposition (EVD) process, or a spray process.

Thereafter, as shown in FIG. 7, the tape (reference numeral 16 of FIG. 5c) is removed. In this case, the conductive material layer 220 formed on the tape 16 is removed, thereby forming the first electrode layer 222 including the electrode part and the first and second extension part.

Subsequently, as shown in FIG. 8, the first electrode 21 including the electrode part 212 having a pattern corresponding to each cell is formed by patterning the first electrode layer 222.

Then, after forming the light absorbing layer (reference numeral 23 of Fig. 2), the buffer layer (reference numeral 25 of FIG. 2), and the high resistance buffer layer (reference number 27 of FIG. 2), the contact pattern (reference numeral 42 of FIG. 2) may be formed, the second electrode (reference numeral 29 of FIG. 2) may be formed, and the division pattern (reference numeral 44 of FIG. 2) may be formed. Accordingly, the solar cell 110 of FIG. 2 may be formed. Since the above process may be variously performed, the detail thereof will be omitted.

According to the present embodiment, the first electrode 21 having the first and second extension parts 214a and 214b may be formed on the bottom surface 14 of the support substrate 10 through the simple process.

Although the tape 16 is used according to the embodiment described above, various schemes such as a scheme of using a mask may be employed.

Hereinafter, a method of fabricating a solar cell according to a second embodiment will be described with reference to FIGS. 9 to 11. FIGS. 9 to 11 are sectional views showing the manufacturing process in a method of fabricating the solar cell according to the second embodiment. Hereinafter, the details of a process identical to or similar to a process of the first embodiment will be omitted, and the process different from the process of the first embodiment will be described.

First, as shown in FIG. 9, a conductive material layer 220 is formed on the whole surface of the support substrate 10 by dipping the support substrate 10 into a plating solution.

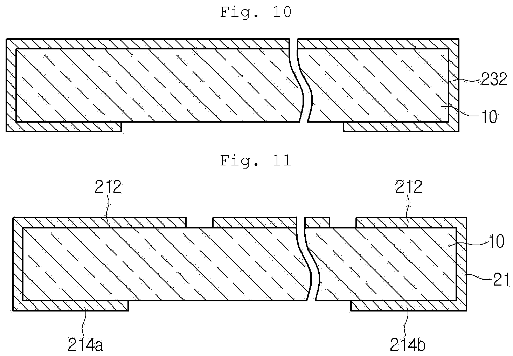

Therefore, as shown in FIG. 10, the first electrode layer 232 may be formed by removing the conductive material layer (reference numeral 230 of FIG. 5a) of the first extension part (reference numeral 214a of FIG. 2) and the second extension part (reference numeral 214b of FIG. 2). In order to remove the conductive material layer 230 between the first and second extension parts 214a and 214b, a mechanical scheme of performing a scribing process using a tip, a laser scheme, an etching scheme, or a sand blast scheme may be used.

Thereafter, as shown in FIG. 11, the first electrode 21 including the electrode part 212 having a pattern corresponding to each solar cell is formed by patterning the first electrode layer 232.

Thereafter, after forming the light absorbing layer (reference numeral 23 of FIG. 2), the buffer layer (reference numeral 25 of FIG. 2), and the high reference buffer layer (reference numeral 27 of FIG. 2), the contact pattern (reference numeral 42 of FIG. 2) is formed, and the second electrode (reference numeral 29 of FIG. 2) is formed. Thereafter, the division pattern (reference numeral 44 of FIG. 2) may be formed. Therefore, the solar cell 110 of FIG. 2 may be formed. Since the above process can be variously performed, the detail thereof will be omitted.

Any reference in this specification to "one embodiment, ""an embodiment, ""example embodiment, "etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within scope of the appended claims. More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art.

## Claims

1. A solar cell (110) comprising:
a support substrate (10) having first (12) and second surfaces (14) opposite to each other;
a photoelectric conversion part (20) disposed on the first surface (12) and including a first electrode (21), a light absorbing layer (23), and a second electrode; and
a collecting electrode electrically connected to the first electrode and disposed on the second surface,
**characterized in that** the first electrode (21) is disposed on the first surface (12) of the support substrate (10), and
**in that** the light absorbing layer (23) is disposed on the first electrode (21),
wherein the second electrode (29) is disposed on the light absorbing layer (23),
wherein the first electrode (21) includes an electrode part (212) disposed on the first surface (12) and an extension part (214a, 214b) extending from the first surface (12) to the second surface (14), and the collecting electrode (30) makes contact with the extension part (214a, 214b),
wherein the first electrode (21) includes molybdenum (Mo), copper (Cu), nickel (Ni), aluminum (Al), or the alloy thereof,
wherein the extension part (214a, 214b) extends from the first surface (12) to the second surface (14) while surrounding both lateral sides of the support substrate (10),
wherein the extension part (214a, 214b) comprises a first extension part (214a) extending from one side of the electrode part and a second extension part (214b) extending from an opposite side of the electrode part and spaced apart from the first extension part (214a) on the second surface (14), and
wherein the collecting electrode (30) comprises a first collecting electrode (31) making contact with the first extension part (214a) and a second collecting electrode (32) making contact with the second extension part (214b).

2. The solar cell (110) of claim 1, wherein first (214a) and second extension parts (214b) have a width of about 60µm or more.

3. The solar cell (110) of claim 1, wherein the photoelectric conversion part (20) includes a plurality of photoelectric conversion parts connected to each other in series, so that the electrode part of the first electrode (21), the light absorbing layer (23), and the second electrode (29) comprises a plurality of electrode parts, a plurality of light absorbing layers, and a plurality of second electrodes, respectively, and
wherein the first extension part (214a) extends from the electrode part of the first electrode (121) that is not connected to the second electrode through a contact pattern (43), and the second extension part (214b) extends from the electrode part of the first electrode (21) that is connected to the second electrode (29) through the contact pattern (42).

4. A solar cell module (100) comprising:
a solar cell (110) as defined in anyone of claims 1 to 3, and
a junction box (120) on the second surface (14) of the support substrate (10) of the solar cell (110).

5. The solar cell module (100) of claim 4, wherein the junction box (120) is positioned on the second surface (14) of the support substrate (10) having the first (31) and second collecting electrodes (32) .

6. The solar cell module (100) of claim 4, wherein an insulating sealing member (60) is formed at the lateral side of the solar cell (110) .

## Patentansprüche

1. Solarzelle (110), umfassend:
ein Trägersubstrat (10), das erste (12) und zweite Flächen (14) aufweist, die einander gegenüberliegen;
einen photoelektrischen Umwandlungsteil (20), der auf der ersten Fläche (12) angeordnet ist und eine erste Elektrode (21), eine lichtabsorbierende Schicht (23) und eine zweite Elektrode einschließt; und
eine Sammelelektrode, die elektrisch mit der ersten Elektrode verbunden und auf der zweiten Fläche angeordnet ist,
**dadurch gekennzeichnet, dass** die erste Elektrode (21) auf der ersten Fläche (12) des Trägersubstrats (10) angeordnet ist, und
dadurch, dass die lichtabsorbierende Schicht (23) auf der ersten Elektrode (21) angeordnet ist,
wobei die zweite Elektrode (29) auf der lichtabsorbierenden Schicht (23) angeordnet ist,
wobei die erste Elektrode (21) einen Elektrodenteil (212) einschließt, der auf der ersten Fläche (12) angeordnet ist, und einen Erstreckungsteil (214a, 214b), der sich von der ersten Fläche (12) zur zweiten Fläche (14) erstreckt, und die Sammelelektrode (30) den Erstreckungsteil (214a, 214b) kontaktiert,
wobei die erste Elektrode (21) Molybdän (Mo), Kupfer (Cu), Nickel (Ni), Aluminium (Al), oder die Legierung davon einschließt,
wobei sich der Erstreckungsteil (214a, 214b) unter Umgeben beider seitlichen Seiten des Trägersubstrats (10) von der ersten Fläche (12) zur zweiten Fläche (14) erstreckt,
wobei der Erstreckungsteil (214a, 214b) einen ersten Erstreckungsteil (214a) umfasst, der sich von einer Seite des Elektrodenteils erstreckt, und einen zweiten Erstreckungsteil (214b), der sich von einer gegenüberliegenden Seite des Elektrodenteils erstreckt und vom ersten Erstreckungsteil (214a) auf der zweiten Fläche (14) beabstandet ist, und
wobei die Sammelelektrode (30) eine erste Sammelelektrode (31) umfasst, die den ersten Erstreckungsteil (214a) kontaktiert, und eine zweite Sammelelektrode (32), die den zweiten Erstreckungsteil (214b) kontaktiert.

2. Solarzelle (110) nach Anspruch 1, wobei erster (214a) und zweiter Erstreckungsteil (214b) eine Breite von etwa 60 µm oder mehr aufweisen.

3. Solarzelle (110) nach Anspruch 1, wobei der photoelektrische Umwandlungsteil (20) eine Vielzahl von photoelektrischen Umwandlungsteilen einschließt, die so miteinander in Reihe geschaltet sind, dass der Elektrodenteil der ersten Elektrode (21), die lichtabsorbierende Schicht (23), und die zweite Elektrode (29) jeweils eine Vielzahl von Elektrodenteilen, eine Vielzahl von lichtabsorbierenden Schichten, und eine Vielzahl von zweiten Elektroden umfassen, und
wobei sich der erste Erstreckungsteil (214a) von dem Elektrodenteil der ersten Elektrode (121) erstreckt, der nicht durch ein Kontaktmuster (43) mit der zweiten Elektrode verbunden ist, und sich der zweite Erstreckungsteil (214b) von dem Elektrodenteil der ersten Elektrode (21) erstreckt, der durch das Kontaktmuster (42) mit der zweiten Elektrode (29) verbunden ist.

4. Solarzellenmodul (100), umfassend:
eine Solarzelle (110) nach einem der Ansprüche 1 bis 3, und
eine Anschlussdose (120) auf der zweiten Fläche (14) des Trägersubstrats (10) der Solarzelle (110).

5. Solarzellenmodul (100) nach Anspruch 4, wobei die Anschlussdose (120) auf der zweiten Fläche (14) des Trägersubstrats (10) positioniert ist, die die erste (31) und zweite Sammelelektrode (32) aufweist.

6. Solarzellenmodul (100) nach Anspruch 4, wobei an der seitlichen Seite der Solarzelle (110) ein isolierendes Dichtungsglied (60) gebildet ist.

## Revendications

1. Cellule solaire (110) comprenant :
un substrat de support (10) ayant des première (12) et seconde surfaces (14) opposées l'une à l'autre ;
une partie de conversion photoélectrique (20) disposée sur la première surface (12) et comportant une première électrode (21), une couche d'absorption de lumière (23), et une deuxième électrode ; et
une électrode collectrice connectée électriquement à la première électrode et disposée sur la seconde surface,
**caractérisée en ce que** la première électrode (21) est disposée sur la première surface (12) du substrat de support (10), et
**en ce que** la couche d'absorption de lumière (23) est disposée sur la première électrode (21),
dans laquelle la deuxième électrode (29) est disposée sur la couche d'absorption de lumière (23),
dans laquelle la première électrode (21) comporte une partie d'électrode (212) disposée sur la première surface (12) et une partie d'extension (214a, 214b) s'étendant de la première surface (12) à la seconde surface (14), et l'électrode collectrice (30) établit un contact avec la partie d'extension (214a, 214b),
dans laquelle la première électrode (21) comporte du molybdène (Mo), du cuivre (Cu), du nickel (Ni), de l'aluminium (Al), ou leurs alliages,
dans laquelle la partie d'extension (214a, 214b) s'étend de la première surface (12) à la seconde surface (14) tout en entourant les deux côtés latéraux du substrat de support (10),
dans laquelle la partie d'extension (214a, 214b) comprend une première partie d'extension (214a) s'étendant d'un côté de la partie d'électrode et une seconde partie d'extension (214b) s'étendant d'un côté opposé de la partie électrode et espacée de la première partie d'extension (214a) sur la seconde surface (14), et
dans laquelle l'électrode collectrice (30) comprend une première électrode collectrice (31) établissant un contact avec la première partie d'extension (214a) et une deuxième électrode collectrice (32) établissant un contact avec la seconde partie d'extension (214b).

2. Cellule solaire (110) selon la revendication 1, dans laquelle les première (214a) et seconde parties d'extension (214b) ont une largeur d'environ 60 µm ou plus.

3. Cellule solaire (110) selon la revendication 1, dans laquelle la partie de conversion photoélectrique (20) comporte une pluralité de parties de conversion photoélectrique connectées les unes aux autres en série, de sorte que la partie d'électrode de la première électrode (21), la couche d'absorption de lumière (23) et la deuxième électrode (29) comprennent une pluralité de parties d'électrodes, une pluralité de couches d'absorption de lumière et une pluralité de secondes électrodes, respectivement, et
dans laquelle la première partie d'extension (214a) s'étend de la partie d'électrode de la première électrode (121) qui n'est pas connectée à la deuxième électrode à travers un motif de contact (43), et la seconde partie d'extension (214b) s'étend de la partie d'électrode de la première électrode (21) qui est connectée à la deuxième électrode (29) à travers le motif de contact (42).

4. Module à cellule solaire (100) comprenant :
une cellule solaire (110) selon l'une quelconque des revendications 1 à 3, et
une boîte de jonction (120) sur la seconde surface (14) du substrat de support (10) de la cellule solaire (110) .

5. Module à cellule solaire (100) selon la revendication 4, dans lequel la boîte de jonction (120) est positionnée sur la seconde surface (14) du substrat de support (10) ayant les première (31) et seconde électrodes collectrices (32).

6. Module à cellule solaire (100) selon la revendication 4, dans lequel un organe d'étanchéité isolant (60) est formé au niveau du côté latéral de la cellule solaire (110).
